# EUROPEAN PATENT APPLICATION

(11) **EP 0 624 803 A1**
(43) Date of publication of application: **17.11.1994**
(21) Application number: 94107285.2
(22) Date of filing: 10.05.1994
(51) Int. Cl.: G01R 31/28

(54) **Circuit tester for electrical protection device**

(30) Priority: 13.05.1993 IT BO930211
(71) Applicant: G. BARGELLINI & C. S.p.A., I-40066 Pieve di Cento, Bologna (IT)
(72) Inventor: Bargellini, Giulio, I-40066 Pieve di Cento (IT)
(74) Representative: Modiano, Guido, Dr.-Ing.

(57) **Abstract**

A circuit device for checking the correct operation of an electrical protection device, particularly of a differential cutout, and of the connection of the ground line in interior wiring, characterized in that it includes a resistor (15,16) insertable between the phase line and the ground line and sized so as to produce such a ground current as to cause the intervention of the differential cutout.

## Description

The present invention relates to a circuit device for checking the correct operation of an electrical protection device, particularly of a differential cutout, and of the connection of the ground line in interior wiring.

It is known that wiring rules prescribe, as a protection device, an efficient grounding system and a differential cutout.

The efficiency of these protection devices can currently be tested only by specialized personnel with the aid of appropriate instruments and thus with very high costs. Furthermore, due to their troublesome nature, these tests are not performed with the necessary frequency, and consequently the actual efficiency of the wiring may remain unknown even for very long periods, with the consequent risks.

A technical aim of the present invention is to provide a device that allows to obviate the shortcomings of the checks currently performed on interior wiring, especially for homes and offices.

Within the scope of this aim, an object of the present invention is to provide a device which has a low cost so that it is affordable for a vast number of potential purchasers.

Another object of the present invention is to provide a device that can be used with maximum safety even by non-experts.

With this aim and this object in view, as well as with others which will become apparent hereinafter, there is provided a device as defined in the appended claims.

Further characteristics and advantages of the device according to the present invention will become apparent from the following detailed description of a preferred embodiment thereof, illustrated only by way of non-limitative example in the accompanying drawing, wherein:
figure 1 is a circuit diagram of an interior wiring for civil use;
figure 2 is a perspective view of the device according to the invention, suitable to check the efficiency of the protection devices of the wiring of figure 1; and
figure 3 is an exploded view of the device of figure 2.

With reference to the above figures, the interior wiring comprises a differential cutout 1 of a commonly commercially available type. The two phase and neutral wires are connected to the input of the switch 1 and continue downstream of the cutout to supply energy to the users of the wiring.

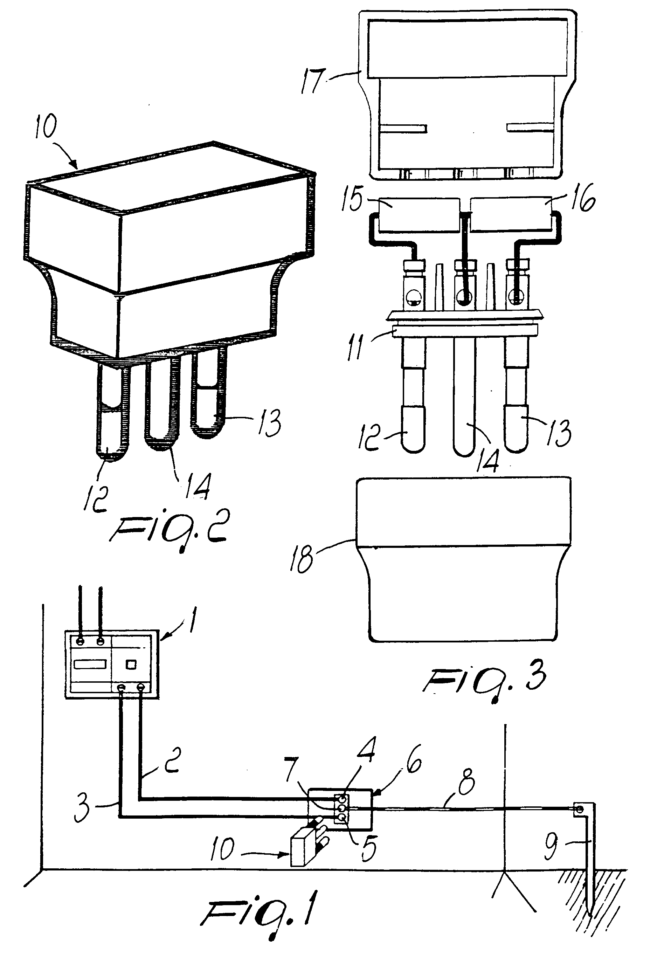

In figure 1, the phase and neutral wires are designated by the reference numerals 2 and 3 respectively and are connected to the terminals 4 and 5 of an outlet 6 provided with a central terminal 7. A wire 8 extends from the terminal 7 and is connected to a ground plate 9 which is planted in the ground for the grounding of the user devices of the system.

Naturally, the system can have other lines for the connection of additional user devices to the power supply and to the ground; these lines are not shown for the sake of descriptive simplicity.

The device, which according to the invention is suitable to check the efficiency of the protection devices of the described wiring, i.e. the differential cutout 1 and the grounding, comprises a plug, generally designated by the reference numeral 10, composed of a flange 11 made of insulating plastic material in which three pins 12, 13 and 14 are anchored in the same way as conventional plugs.

The pins 12 and 13 are used for connection to the phase 2 and to the neutral 3, and are thus suitable to be inserted in the terminals 4 and 5. The pin 14 is instead suitable to engage the ground terminal 7.

The pins 12, 13 and 14 have, on the side located inside the flange 11, screw terminals for the electrical connection of two resistors 15 and 16 in which one terminal is connected to the ground pin 14 and the opposite terminal is connected to a respective phase pin 12 and 13.

The resistors 15 and 16 are protected by a casing 17, which is formed by two half-shells coupleable to the flange in a snap-together manner or by means of screws and shaped so as to act as a handgrip, in order to allow the user to insert the plug 10 in the outlet and remove it.

The resistors 15 and 16 are sized so as to allow a controlled flow of current, between the phase line and the ground line, that is higher than the value for which the differential cutout is set.

Thus, when the wiring is to be checked and the plug 10 is inserted in the outlet 6, current flows between the phase line and the ground; if the differential cutout is efficient and the ground line is not interrupted, this flow causes the intervention of the differential cutout and the immediate disconnection of the power supply.

If instead the differential cutout does not intervene, this means that there are defects in the cutout or in the ground line.

It should be noted that in practice there is no difference of potential between the neutral wire and the ground line, so that when the plug is inserted in the outlet no current flows across the resistor connecting the associated pins, and accordingly this resistor could even be omitted. However, its presence is convenient, since usually it is not known which of the two pins 12 and 13 is connected to the phase line, so that if a single resistor were used it would be necessary to make two attempts, one with the plug upright and one with the plug upside down, to make sure that the resistor has been connected between the phase and the ground.

As can be seen, the invention perfectly achieves the intended aim and objects. In particular, the wiring can be checked by the users without the aid of technicians and at any interval.

The described device is susceptible to modifications and variations which are within the scope of the inventive concept. In one of these modifications, the resistors are suitable to disconnect automatically, for example by including a PTC resistor that interrupts the flow of current when the temperature of the resistor, as a consequence of this flow, exceeds a preset value.

Advantageously, in order to protect the pins 12, 13 and 14 it is possible to provide a cap 18 that can be coupled to the casing 17 (figure 3).

According to a further embodiment of the invention, the resistors can be connected by means of a button or of a mechanical or electronic switch.

Furthermore, the results of the check may be displayed by a light-emitting indicator.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. Circuit device for checking the correct operation of an electrical protection device, particularly of a differential cutout (1), and of the connection of the ground line (8) in interior wiring, characterized in that it comprises at least one resistor (15, 16) that can be inserted between the phase line (2) and the ground line (3) and is sized so as to produce such a ground current as to cause the intervention of the differential cutout if the electrical protection device, comprising said differential cutout, is operating correctly.

2. Device according to claim 1, characterized in that it comprises a plug (10) provided with two pins (12, 13) for connection to a phase line (2) and to a neutral line (3), and a pin (14) for connection to the ground line (8), said pin (14) for connection to the ground line (8) being connected to at least one of the two pins associated with the phase line and the neutral line through a resistor (15, 16) sized so as to produce such a ground current as to cause the intervention of the differential cutout (1) if the electrical protection device, comprising said differential cutout, is operating correctly.

3. Device according to claim 2, characterized in that both pins (12, 13) for connection to the phase line (2) and to the neutral line (3) are connected to the pin (14) for connection to the ground line (8) through respective resistors (15, 16).

4. Device according to claims 1 to 3, characterized in that said resistors (15, 16) are suitable to disconnect automatically after a preset time.

5. Device according to one of claims 2 and 3, characterized in that said resistors are accommodated in a casing (17) of the plug (10) which acts as a handgrip.

6. Device according to claim 5, characterized in that said pins (12, 13, 14) are protected by a cap (18) which can be coupled to said plug (10).

7. Device according to one or more of the preceding claims, characterized in that the resistors (15, 16) are connected by means of a pushbutton or of a mechanical or electronic switch.

8. Device according to one or more of the preceding claims, characterized in that the results of the check are displayed by a light-emitting indicator.
